# EUROPEAN PATENT APPLICATION

(11) **EP 3 694 297 A2**
(43) Date of publication of application: **12.08.2020**
(21) Application number: 19210326.5
(22) Date of filing: 20.11.2019
(51) Int. Cl.: H05K 3/28, H05K 3/22, C23C 16/02, C23C 16/455, C23C 28/04

(54) **METHOD FOR REPAIRING COATED PRINTED CIRCUIT BOARDS**

(30) Priority: 07.02.2019 US 201916270383
(71) Applicant: Hamilton Sundstrand Corporation, Charlotte, NC 28217-4578 (US)
(72) Inventor: SHEEDY, Paul, Bolton, CT 06043 (US); POTEET, Steven, Hamden, CT 06518 (US); SCHMIDT, Wayde R., Pomfret Center, CT 06259 (US); MAGDEFRAU, Neal, Tolland, CT 06084 (US)
(74) Representative: Dehns

(57) **Abstract**

A method for repairing a printed circuit board (PCB) including the steps of presenting a PCB (10) having an initial coating on a surface thereof, removing the initial coating from the surface of the PCB (10) at least in an area in need of repair, and recoating at least the area of the PCB (10) in need of repair by way of atomic layer deposition.

## Description

### BACKGROUND OF THE INVENTION

### 1. Field of the Invention

The subject invention is directed to a method for reworking or repairing printed circuit boards, and more particularly, to a method of repairing coated printed circuit boards using atomic layer deposition techniques.

### 2. Description of Related Art

Printed circuit boards (PCBs) are currently coated with Parylene conformal coatings. These coatings are ultra-thin and pinhole-free, providing a number of high-value surface treatment properties such as excellent moisture, chemical, and dielectric barrier properties, thermal and UV stability, and dry-film lubricity. These properties make Parylene coatings an ideal choice for electronics applications in the aerospace industry.

Parylene is a generic name for members of a unique polymer series, the basic member of which is Parylene N or poly(para-xylylene). A second commercially available member of the Parylene series is Parylene C, which is produced from the same raw material (dimer) as Parylene N, modified only by the substitution of a chlorine atom for one of the aromatic hydrogens. Parylene C has a useful combination of electrical and physical properties, plus very low permeability to moisture and corrosive gases.

While it is an excellent moisture barrier, Parylene C is difficult to remove from the surface of a PCB and recoat, as it does not adhere well to itself post deposition. Rework often requires stripping the entire PCB, re-masking and then recoating. Thus, PCBs that require excessive rework are often discarded.

Atomic layer deposition (ALD) has been used for over a decade in semiconductor and other microelectronic applications for producing conformal coatings, moisture barriers, etc. The industry is beginning to explore the use of ALD for PCB coatings, due to the ability to batch coat, provide for thin coatings that are more robust to oxidation and high temperatures, to coat complex shapes, and create chemically-bonded, pinhole-free coatings that are orders of magnitude more resistant to moisture than typical Parylene C coatings.

The subject invention seeks to utilize ALD to improve rework and re-processing of Parylene C (and other) coated PCBs, including the use of spatial or localized ALD techniques. The primary benefits include improved manufacturing, especially with the repair of PCBs previously coated with Parylene C, including site selective repair. Additional benefits include enhanced chemical bonding to the substrate, improved oxidation resistance, little to no UV degradation and higher temperature stability.

### SUMMARY OF THE DISCLOSURE

The subject invention is directed to a new and useful method for reworking or repairing a printed circuit board (PCB). More particularly, the subject invention is directed to a method of repairing a PCB, which includes the steps of presenting a PCB having an initial coating on a surface thereof, removing the initial coating from the surface of the PCB at least in an area in need of repair, and recoating at least the area of the PCB in need of repair by way of atomic layer deposition.

Preferably, the step of recoating at least the area of the PCB in need of repair involves recoating with nanolaminates composed of a metal oxide. More particularly, the step of recoating at least the area of the PCB in need of repair involves recoating the surface of the PCB with nanolaminates composed of an aluminum oxide (Al₂O₃) and titanium dioxide (TiO₂) composition.

It is envisioned that the step of removing the initial coating at least in the area in need of repair involves mechanical, chemical, or external energy based removal techniques, and the step of recoating at least the area of the PCB in need of repair involves plasma enhanced or thermal atomic layer deposition.

The method further includes the step of masking the surface of the PCB to isolate at least the area in need of repair for recoating, and the step of preparing the surface of the PCB at least in the area in need of repair for recoating by way of a plasma process.

It is also envisioned that the step of recoating at least the area of the PCB in need of repair involves spatial or localized atomic layer deposition. In this regard, it is envisioned that at least the step of recoating the PCB involves utilizing a localized energy source delivered through a nozzle assembly. The method would thus involve the step of moving the nozzle assembly relative to the PCB, or the step of moving the PCB relative to the nozzle assembly.

It is envisioned that the step of recoating at least the area of the PCB in need of repair would involve depositing a coating by way of atomic layer deposition that has a thickness of about 50 nanometers (nm) to about 1 micron (µ). It is further envisioned that the method could involve recoating the entire surface of the PCB by way of atomic layer deposition, rather than just recoating the area of the PCB in need of repair.

These and other features of the method of the subject invention will become more readily apparent to those having ordinary skill in the art to which the subject invention appertains from the detailed description of the preferred embodiments taken in conjunction with the following brief description of the drawings.

### BRIEF DESCRIPTION OF THE DRAWINGS

So that those having ordinary skill in the art will readily understand how to perform the method of the subject invention without undue experimentation, preferred embodiments thereof will be described in detail herein below with reference to the figures wherein:
Fig. 1 is a schematic view of a PCB with an initial conformal coating;
Fig. 2 is a schematic view of the PCB shown in Fig. 1, with the initial conformal coating removed in an area in need of repair;
Fig. 3 is a schematic view of the PCB shown in Fig. 2, wherein the area in need of repair has been recoated;

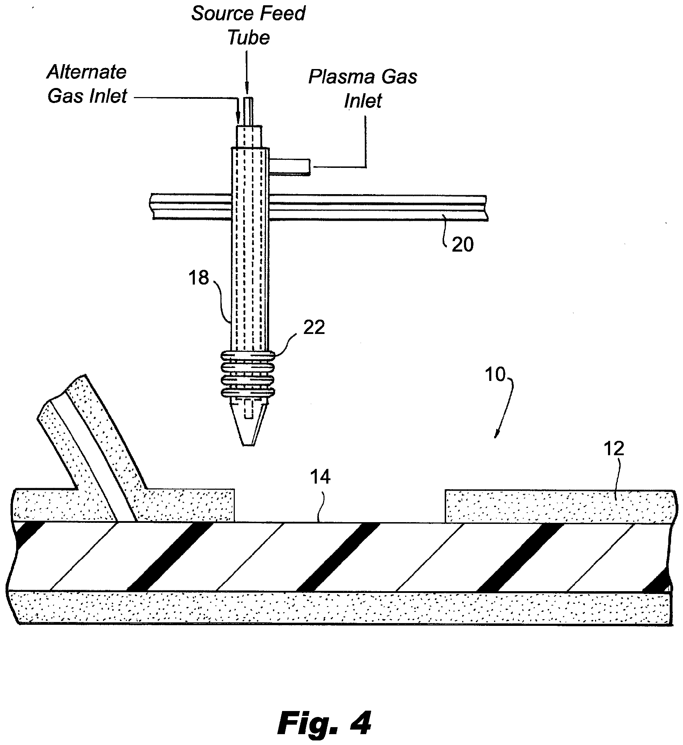

Fig. 4 is a schematic view of a PCB with an initial conformal coating, which has been removed in an area in need of repair by way of a nozzle assembly; and

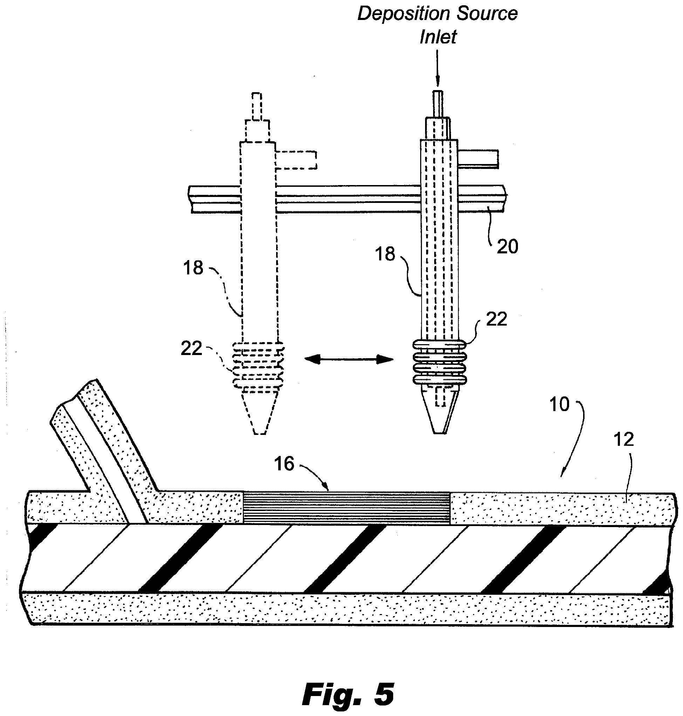

Fig. 5 is a schematic view of the PCB shown in Fig. 5, wherein the area in need of repair is recoated utilizing the nozzle assembly.

### DETAILED DESCRIPTION OF THE PREFERRED EMBODIMENTS

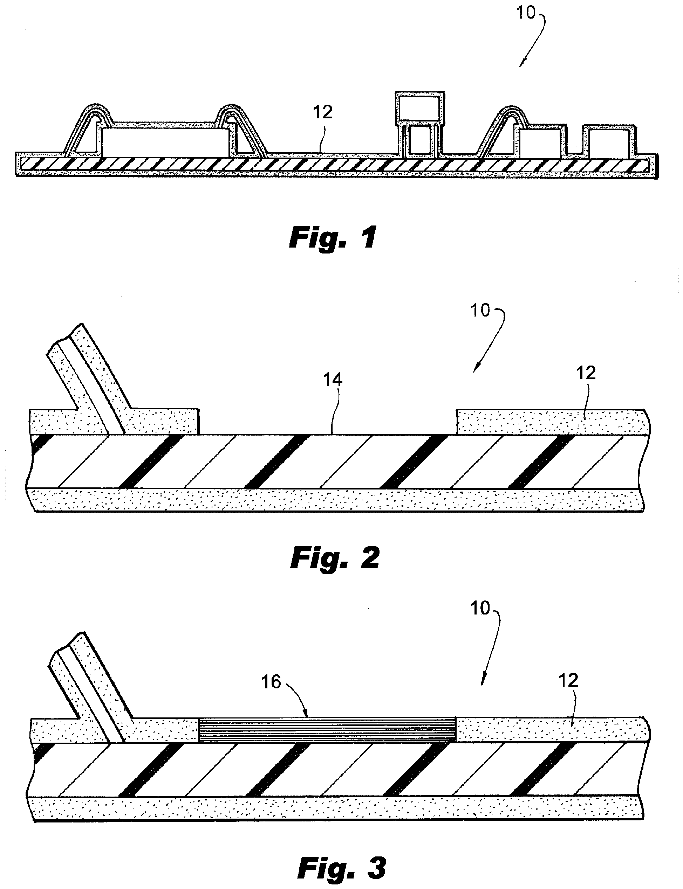

The subject invention is directed to a new and useful method for reworking or otherwise repairing a printed circuit board (PCB), an example of which is illustrated schematically in Fig. 1 and designated generally by reference numeral 10. PCB 10 has an initial conformal coating 12 on all of the surfaces thereof, including on the surfaces of the components included thereon.

The initial coating 12 is preferably a Parylene coating, and more preferably, the initial coating 12 is an ultra-thin Parylene C coating, which has a useful combination of electrical and physical properties, plus very low permeability to moisture and corrosive gases. Alternatively, the initial coating could be an acrylic coating or a urethane coating, as is known in the art. Additional environmentally stable coatings are also contemplated.

The method of the subject invention includes the step of locally removing the initial coating 12 from the surface of the PCB 10 at least in an area in need of repair 14, as illustrated schematically in Fig. 2. This can be accomplished in different ways and by different means. For example, it is envisioned that the step of removing the initial coating 12 at least in the area 14 of the PCB 10 that is in need of repair could involve mechanical removal by way of rubbing, abrading or stripping using specialized media blasting. Alternatively, the step of removing the initial coating 12 could involve chemical removal using chemical stripping agents. It is also envisioned that the step of removing the initial coating 12 could involve the interaction of external energy (e.g., laser, radiation or a plasma beam) with the coating material so that the coating would be selectively removed from the PCB. Those skilled in the art will readily appreciate that the optimal coating removal technique employed will typically depend upon the type of coating to be removed from the PCB.

The method of the subject invention further includes the step of recoating at least the area 14 of the PCB 10 that is in need of repair, as illustrated schematically in Fig. 3. In accordance with a preferred embodiment of the subject invention, the step of recoating the PCB shown in Fig. 3 is accomplished by way of atomic layer deposition (ALD), including plasma enhanced or thermal ALD.

ALD is a thin-film deposition technique that is based on the sequential use of a gas phase chemical process. The majority of ALD reactions use two chemicals, typically called precursors. These precursors react with the surface of a material one at a time in a sequential, self-limiting manner. Through repeated cyclic exposure to separate precursors, a thin film is slowly deposited. This ensures absolute thickness control, extreme layer homogeneity nominally without porosity or pinholes and superb conformity, even of high aspect ratio surfaces often found on a PCB.

Preferably, the step of recoating at least the area 14 of the PCB 10 that is in need of repair by way of ALD involves recoating the PCB 10 with nanolaminates 16 composed of a metal oxide. For example, the step of recoating at least the area 14 of the PCB 10 that is in need of repair involves recoating the surface area 14 of the PCB 10 with nanolaminates composed of an aluminum oxide (Al₂O₃) and titanium dioxide (TiO₂) composition. Those skilled in the art will readily appreciate that other types of ALD coatings can be employed, such as for example coatings of silicon dioxide (SiO₂) compositions or the like. Other coating architectures and compositions are also contemplated. In one example, the coating deposited in the recoating step consists of a layer with nominally a single composition. In other examples, the coatings deposited in the recoating step consist of two or more alternating layers with different compositions and different or nominally a single composition 'doped' with a second composition. Other ceramic, organic and hybrid-inorganic coating options are also contemplated.

It is envisioned that the method of the subject invention would also include the step of masking the surface of the PCB 10 to isolate at least the area that is in need of repair for recoating. It is also envisioned that the method of the subject invention could include the step of preparing the surface of the PCB at least in the area in need of repair for recoating. This step could be accomplished by way of a plasma process, a chemical pretreatment or by other means known in the art.

It is envisioned that the step of recoating at least the area of the PCB 10 in need of repair could involve either spatial or localized ALD. Those skilled in the art will readily appreciate that spatial ALD is an enhanced form of traditional ALD, improving the deposition rate by several orders of magnitude. Moreover, instead of filling and flushing a process chamber repeatedly, spatial ALD uses a multitude of precursor zones through which the substrates pass at high speed. Gas bearing and exhaust slits in between the precursor zones, keep the precursors from mixing avoiding parasitic deposition.

It is envisioned that the step of recoating the PCB 10 could involve utilizing a localized energy source delivered through a nozzle assembly 18, as illustrated for example schematically in Fig, 4. The nozzle assembly 18 would preferably include an elongated tubular body with an outer diameter of about 0.25 inches, and having an energizing coil 22 provided on a distal end portion thereof (e.g., a radio frequency coil), a first inlet for receiving a plasma gas (e.g., Oxygen, Argon or Helium), a second inlet for receiving an alternate gas (e.g., an inert purge gas such as argon or nitrogen), and a deposition source inlet for receiving the metal oxide composition to be deposited by the nozzle through ALD. An example of such an assembly is disclosed in commonly assigned U.S. Patent Application Publication 2019/0037678, the disclosure of which is herein incorporated by reference in its entirety.

The nozzle assembly 18 could also be used to remove the initial coating 12 from the area of the PCB 10 that is in need of repair. That is the nozzle assembly 18 could generate a cleaning plasma beam to locally remove or otherwise volatilize the initial coating 12 in the area of the PCB 10 that is in need of repair. Various nozzle assemblies (tube, plate, slot, etc.) with single or multiple nozzle configurations are contemplated.

The method would further involve the step of moving the nozzle assembly 18 relative to the PCB 10 by way of a multi-axis maneuvering system 20, as shown for example in Fig, 5. Alternatively, the PCB 10 could be moved relative to the nozzle assembly 18 by placing the PCB on a multi-axis working surface (not shown).

It is envisioned that the step of recoating at least the area of the PCB 10 in need of repair would involve depositing a coating by way of atomic layer deposition that has a thickness of about 50 nanometers (nm) to about 1 micron (µ), and more preferably, a thickness of 50 - 100 nm. It is further envisioned that the method could involve recoating the entire surface of the PCB by way of atomic layer deposition, rather than just recoating the area of the PCB in need of repair.

It has been determined through experimentation that a PCB having an initial coating of Parylene C, that has been mechanically removed and recoated with nanolaminates composed of an aluminum oxide (Al₂O₃) and titanium dioxide (TiO₂) in accordance with the method of the subject invention possesses favorable properties such as moisture and insulation resistance (MIR), hydrolytic stability, mechanical flexibility and dielectric barrier.

While the subject disclosure has been shown and described with reference to preferred embodiments, those skilled in the art will readily appreciate that changes and/or modifications may be made thereto without departing from the scope of the subject disclosure.

## Claims

1. A method for repairing a printed circuit board (PCB) comprising:
a) presenting a PCB (10) having an initial coating (12) on a surface thereof;
b) removing the initial coating (12) from the surface of the PCB (10) at least in an area in need of repair; and
c) recoating at least the area of the PCB (10) in need of repair by way of atomic layer deposition.

2. A method for repairing a printed circuit board (PCB) according to Claim 1, wherein the step of recoating at least the area of the PCB (10) in need of repair involves recoating with nanolaminates composed of a metal oxide.

3. A method for repairing a printed circuit board (PCB) according to Claim 1, wherein the step of recoating at least the area of the PCB in need of repair involves recoating with nanolaminates composed of an aluminum oxide (Al₂O₃) and titanium dioxide (TiO₂) composition.

4. A method for repairing a printed circuit board (PCB) according to any preceding claim, wherein the initial coating is a parylene coating, an acrylic coating or a urethane coating.

5. A method for repairing a printed circuit board (PCB) according to any preceding claim, further comprising the step of masking the surface of the PCB (10) to isolate at least the area in need of repair for recoating.

6. A method for repairing a printed circuit board (PCB) according to any preceding claim 1, further comprising the step of preparing the surface of the PCB (10) at least in the area in need of repair for recoating by way of a plasma process.

7. A method for repairing a printed circuit board (PCB) according to any preceding claim, wherein the step of removing the initial coating at least in the area in need of repair involves mechanical, chemical or external energy based removal techniques.

8. A method for repairing a printed circuit board (PCB) according to any preceding claim, wherein the step of recoating at least the area of the PCB (10) in need of repair involves plasma enhanced or thermal atomic layer deposition.

9. A method for repairing a printed circuit board (PCB) according to any of claims 1 to 8, wherein the step of recoating at least the area of the PCB (10) in need of repair involves spatial or localized atomic layer deposition.

10. A method for repairing a printed circuit board (PCB) according to any of claims 1 to 8, wherein at least the step of recoating the PCB (10) involves utilizing a localized energy source delivered through a nozzle assembly (18).

11. A method for repairing a printed circuit board (PCB) according to Claim 10, further comprising the step of moving the nozzle assembly (18) relative to the PCB (10).

12. A method for repairing a printed circuit board (PCB) according to any preceding claim, further comprising the step of moving the PCB (10) relative to the nozzle assembly.

13. A method for repairing a printed circuit board (PCB) according to any preceding claim, wherein the step of removing the initial coating from the surface of the PCB (10) and the step of recoating the PCB (10) involves utilizing a localized energy source delivered through a nozzle assembly.

14. A method for repairing a printed circuit board (PCB) according to any preceding claim, wherein the step of recoating at least the area of the PCB (10) in need of repair involves depositing a coating having a thickness of 50 nm to 1 µ.

15. A method for repairing a printed circuit board (PCB) according to any preceding claim, comprising recoating the entire surface of the PCB (10) by way of atomic layer deposition.
